# FASCICULE DE BREVET EUROPEEN

(11) **EP 3 839 627 B1**
(45) Date de publication et mention de la délivrance du brevet: **26.07.2023**
(21) Numéro de dépôt: 19217760.8
(22) Date de dépôt: 18.12.2019
(51) Int. Cl.: G03F 7/00, G04D 3/00, C25D 1/00, C25D 5/02, G04B 13/02

(54) **METHODE DE FABRICATION D'UN MICROMOULE POUR ELECTROFORMAGE DE COMPOSANTS MICROMECANIQUES**
HERSTELLUNGSMETHODE EINER MIKROFORM FÜR DIE GALVANOFORMUNG VON MIKROMECHANISCHEN KOMPONENTEN
METHOD FOR MANUFACTURING A MICROMOULD FOR ELECTROFORMING OF MICROMECHANICAL COMPONENTS

(43) Date de publication de la demande: 23.06.2021
(73) Titulaire: Mimotec S.A., 1950 Sion (CH)
(72) Inventeur: LORENZ, Hubert, 1965 Savièse (CH); GENOLET, Grégoire, 1926 Fully (CH); MARTINS, John, 1957 Ardon (CH)
(74) Mandataire: Wenger, Joel-Théophile

(56) Documents cités:
- EP-A1- 3 508 916
- EP-A1- 3 547 027
- WO-A1-2018/172894

## Description

### Domaine de l'invention

La présente demande concerne le domaine de la fabrication de micromoules pour composants micromécaniques métalliques par électroformage en particulier des composants micromécaniques à plusieurs niveaux utilisés notamment dans l'horlogerie.

### Arrière-plan technique de l'invention

On trouve dans la littérature des documents proposant la réalisation de moules d'électroformage à un ou plusieurs niveaux. Une fois réalisé, ce moule est utilisé pour la fabrication de pièces micromécaniques via une étape d'électroformage. Pour cela, le moule doit comprendre des parties électriquement conductrices afin que cette étape puisse s'effectuer correctement. Le fond du moule ainsi que les surfaces horizontales sont métallisées à cet effet. Dans le cas de la fabrication de composants micromécaniques à plusieurs niveaux utilisés notamment dans l'horlogerie, il est préférable que la surface supérieure ou sommitale du moule ne soit pas conductrice. En effet, des vitesses de croissance variables dans le moule peuvent provoquer un remplissage de la cavité par le dessus du moule, si la surface supérieure de cette dernière est conductrice.

Le brevet EP1681375B1 se propose de réaliser le dorage sur le premier étage illuminé d'un moule multi-niveaux de photorésist et avant son développement. La méthode permet d'obtenir la couche conductrice uniquement sur le premier niveau du moule. Cette méthode utilise une technique de lift-off qui nécessite un photomasque supplémentaire et de nombreuses opérations additionnelles.

Le brevet EP2053146B1 réalise également la métallisation sur le premier étage de photorésist illuminé et avant son développement. Elle permet également d'obtenir la couche conductrice uniquement sur le premier niveau du moule. La méthode utilise une technique de gravure chimique et nécessite un photomasque supplémentaire et de nombreuses opérations additionnelles.

Un inconvénient supplémentaire de ces deux méthodes réside dans le fait que lors de l'illumination de la couche supplémentaire de photorésist (le deuxième étage) la lumière UV se réfléchit sur la couche conductrice et que des rayonnements parasites sont créés. La qualité optique de la surface de photorésist n'étant pas aussi bonne que la qualité optique du dessus du support.

La demande de brevet EP2316056B1 propose de former la surface conductrice ajourée une fois le micromoule réalisé et développé. Le brevet revendique la formation d'une surface conductrice au fond des dites ouvertures et sur les surfaces horizontales sans que les parois verticales ne soient recouvertes de métallisation. Mais aucune méthode de réalisation de cette métallisation n'est donnée dans le document. De plus, bien que l'étape de dépôt de la couche conductrice sur un moule terminé simplifie le procédé de fabrication, elle a l'inconvénient de former une couche conductrice également sur la partie sommitale du moule. Cette couche conductrice sommitale ne permet pas un remplissage correct du moule, car elle est la cause d'un remplissage du moule également par le dessus.

Une méthode connue pour enlever la couche conductrice sommitale décrite dans la demande EP3547027A1, est l'usinage mécanique de cette dernière. Néanmoins cet usinage de la couche conductrice est délicat et peut créer des bavures et détruire les structures fines du moule en résine. Cette demande EP3547027A1 décrit également une autre méthode pour éviter d'avoir la surface sommitale du moule conductrice. Il s'agit de recouvrir cette couche par une matière isolante à l'aide d'un tampon afin de la neutraliser. Néanmoins, la tenue de cette couche est difficile à garantir dans la durée et dans les bains chimiques utilisés pour l'électroformage.

Le document WO2018/172894 décrit un procédé pour la réalisation d'un micro-moule pour un composant horloger et la question de l'application d'une couche partielle a été répondue par des méthodes telles l'épargne ou le lift-off, pour ne recouvrir que la partie désirée de la surface, ou encore la gravure après déposition, pour retirer les parties non désirées de la couche.

Le document EP 3 508 916 décrit la réalisation d'un micro-moule pour électroformage à deux niveaux. Un tampon encreur est utilisé pour protéger la couche métallique sommitale de l'attaque chimique. Ainsi, la partie recouverte par la couche d'encre ne sera pas attaquée et la couche métallique sera intacte.

L'invention proposée a pour but d'empêcher une croissance galvanique parasite sur la surface sommitale du moule.

### Brève description de l'invention

Selon la présente demande, il est proposé une méthode de fabrication de micromoules pour électroformage d'un composant micromécanique ayant au moins deux niveaux, cette méthode comprenant les étapes suivantes :
a) appliquer sur un substrat, illuminer et développer au moins deux couches de photorésist, soit une première couche et une couche sommitale pour obtenir un micromoule à au moins deux niveaux en photorésist polymérisé comprenant au moins une cavité comportant un fond formé par une première couche conductrice recouvrant le substrat, des surfaces horizontales supérieures du premier niveau, des surfaces horizontales supérieures de la couche sommitale et des flancs verticaux,
b) déposer une couche conductrice sur le fond de la cavité et sur les surfaces horizontales supérieures du premier niveau, le dépôt de cette couche comprenant les étapes :
   i) appliquer une encre sur tout ou partie des surfaces horizontales de la couche sommitale de photorésist par transfert mécanique d'un encreur,
   ii) déposer une couche conductrice sur le micromoule par une évaporation sous vide directionnelle parallèle aux flancs verticaux de la cavité afin de minimiser l'épaisseur de métal déposé sur ces flancs verticaux, l'épaisseur de métal déposée sur les flancs verticaux étant plus faible que celle déposée sur les surfaces horizontales,
   iii) éliminer la deuxième couche conductrice recouvrant les flancs verticaux de la cavité par attaque chimique contrôlée, ladite deuxième couche conductrice recouvrant uniquement le fond de la cavité et les surfaces horizontales supérieures du premier niveau et de la couche sommitale.
   iv) éliminer l'encre entraînant l'élimination de la couche conductrice placée sur ladite encre.

Ainsi selon la présente méthode, la surface supérieure ou sommitale du moule sera exempte de couche conductrice. Les étapes iii) et iv) peuvent être interverties.

L'application de l'encre sur tout ou partie des surfaces horizontales de la couche sommitale de photorésist peut se faire par transfert mécanique d'un encreur tel qu'un tampon ou un rouleau sur lequel l'encre sera déposée. Par rotation dudit rouleau sur une surface enduite d'encre, l'encre est chargée sur le rouleau et ce dernier vient se positionner au-dessus du moule. Une seconde opération de rotation du rouleau, au contact du moule, va déposer l'encre sur le moule.

Lors de la réalisation d'un moule à plus de deux niveaux, une ou plusieurs couches de photorésist intermédiaire sont utilisées. Chacune de ces couches définit des surfaces verticales et horizontales du moule. Lors de l'étape de dépôt d'une couche conductrice sur le moule, cette couche intermédiaire sera traitée comme la première couche, à savoir que sur les surfaces verticales de la couche intermédiaire, la couche conductrice sera enlevée alors que sur les surfaces horizontales, la couche conductrice va demeurer.

### Description sommaire des figures

L'invention sera mieux comprise grâce à la description qui va suivre et qui se réfère aux dessins annexés donnés à titre d'exemple nullement limitatif, à savoir:
La figure 1 illustre un exemple d'un moule à deux niveaux obtenu par photolithographie.
La figure 2 illustre une étape de préparation consistant à déposer une encre sur la surface supérieure du moule.
La figure 3 illustre le moule avec une couche d'encre sur la surface supérieure du moule.
La figure 4 illustre le moule après une étape de métallisation ou dépôt de couche conductrice.
La figure 5 illustre le moule après l'étape d'attaque chimique contrôlée.
La figure 6 illustre le moule résultant prêt pour l'étape d'électroformage après dissolution de l'encre déposée. La dissolution de l'encre emporte la fine couche conductrice avec elle.
La figure 7 est une variante d'exécution illustrant le moule après une étape de métallisation ou dépôt de couche conductrice.
La figure 8 illustre le moule après l'étape d'attaque chimique contrôlée.
La figure 9 illustre l'étape d'application de l'encre protectrice sur la surface supérieure du moule.
La figure 10 illustre le moule prêt pour l'étape d'électroformage.
La figure 11 illustre une vue en perspective du micromoule à deux niveaux résultant de la méthode proposée dans la présente invention.

### Description détaillée de l'invention

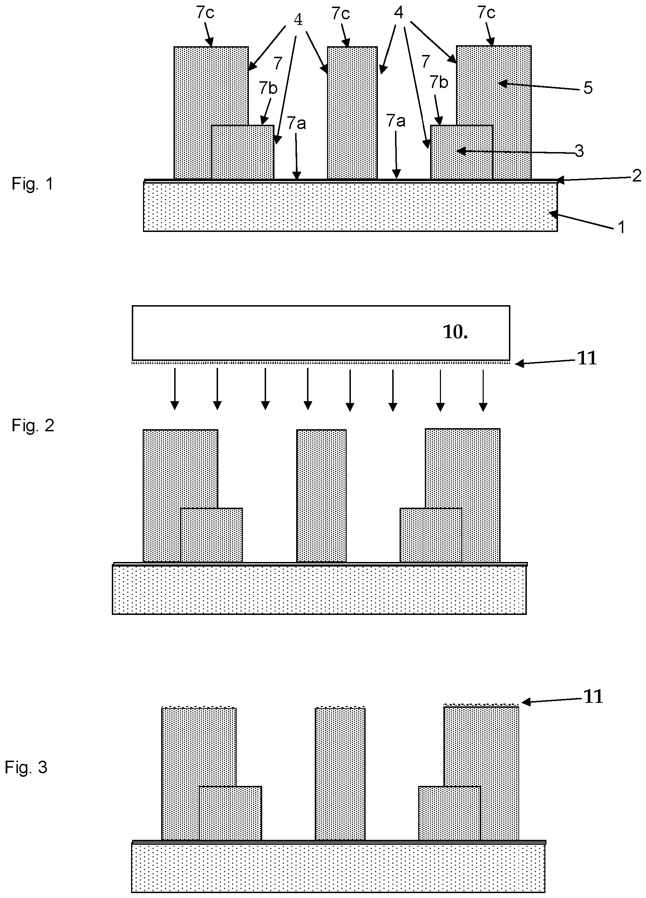

La fabrication de micromoules pour électroformage en photoresist est bien connue et est basée sur l'application de couches de photoresist qui sont exposées au travers d'un photomasque définissant la forme désirée, puis développées. Une fois développé, un moule est réalisé et peut être utilisé pour l'étape d'électroformage. Ce moule tel qu'illustré à la figure 1 comprend au moins deux niveaux réalisés par le dépôt successif, l'illumination et le développement d'au moins deux couches (3, 5) de photoresist sur un substrat 1 sur lequel une première couche conductrice 2 a été préalablement déposée.

Pour la suite de l'exposé, l'exemple à deux niveaux a été choisi. Dans le cas d'un moule à plus de deux niveaux, une ou des couches intermédiaires seront utilisées. Ces couches intermédiaires seront traitées d'une manière identique à la première couche.

Ce micromoule de la figure 1 comporte ainsi une cavité 7 à deux niveaux avec des surfaces horizontales 7a, 7b et 7c et des flancs verticaux 4. Le fond 7a de la cavité 7 est constitué par la couche conductrice 2 recouvrant le substrat 1. Le premier niveau est constitué par la première couche de photorésist 3 avec des surfaces horizontales supérieures 7b. Le deuxième niveau du micromoule est constitué par la deuxième couche de photorésist 5 avec des surfaces horizontales supérieures 7c.

Afin d'éviter un remplissage inhomogène et non-contrôlé du moule, les surfaces horizontales 7a et 7b doivent être conductrices, alors que les faces verticales 4 ainsi que les surfaces horizontales 7c doivent être isolantes. Dans une variante de l'invention les surfaces horizontales 7c peuvent être partiellement isolantes.

Une méthode simple pour rendre les surfaces horizontales 7b conductrices est de déposer une couche conductrice sur le micromoule par une évaporation sous vide directionnelle parallèle aux flancs verticaux 4 de la cavité 7 afin de minimiser l'épaisseur de métal déposé sur ces derniers, l'épaisseur de métal déposée sur les flancs verticaux étant plus faible que celle déposée sur les surfaces horizontales 7a, 7b et 7c. Ce procédé d'évaporation sous vide va donc rendre conductrice, entre autres, les surfaces horizontales 7c, ce qui peut créer des défauts de remplissage lors de l'électroformage. En effet, un contact précoce de ces surfaces 7c peut engendrer un remplissage du micromoule par le dessus.

Afin d'éviter ce genre de défaut, la présente invention propose une méthode afin de ne pas avoir de couche conductrice sur les surfaces horizontales 7c. Cette méthode est décrite ci-après :

### A. Encrage avant dépôt de la couche conductrice

Une encre 11 à base de solvants de la famille de celles utilisées en tampographie, par exemple l'encre AR 101 de l'entreprise TecaPrint, est appliquée sur un élément de transfert d'encre ou tampon encreur, représenté à la Figure 2 sous forme d'une plaque de transfert 10. Lors de l'application de cette plaque 10 sur les reliefs 7c, cette couche 11 d'une épaisseur typique entre 1 et 20um va être transférée sur les surfaces supérieures du moule 7c en contact. L'application de l'encre peut également se faire à l'aide d'un rouleau encreur.

Le résultat de cette étape d'encrage est visible à la figure 3 où seule l'encre 11 qui a été en contact avec la partie supérieure du moule est transférée sur les surfaces supérieures 7c. Cette méthode permet d'appliquer l'encre 11 uniquement sur les surfaces horizontales supérieures 7c du photorésist. L'encre 11 fait office de couche de protection des surfaces supérieures 7c. La couche de protection 11 qui n'a pas été en contact avec les surfaces horizontales supérieures du photorésist reste sur la plaque de transfert 10. Il est à noter que la plaque de transfert 10 ou le rouleau sont légèrement souples pour épouser les contours formés par l'ensemble des parties supérieures des micromoules. Selon un exemple de réalisation, l'encreur est à base de matière silicone afin de permettre un dépôt d'encre homogène. Il n'est pas nécessaire que toute la surface supérieure du moule soit recouverte d'encre mais au minimum les abords des cavités 7.

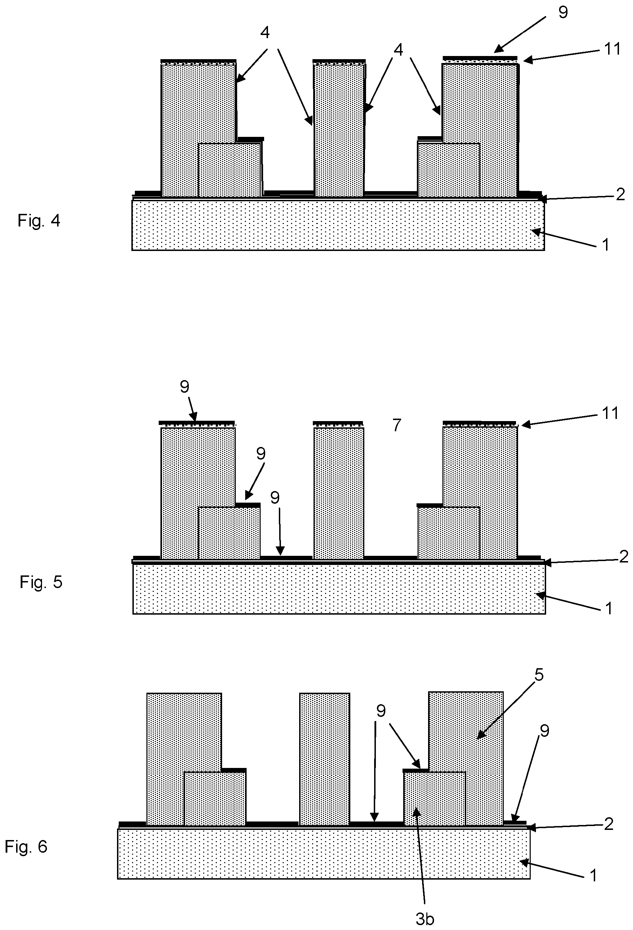

La figure 4 montre le résultat après le dépôt d'une seconde couche conductrice, sur le moule. La couche conductrice 9 va recouvrir l'encre de protection 11 et toutes les surfaces et parois du moule.

Cette couche conductrice 9, généralement formée d'un empilement d'une couche de chrome et d'or, est déposée par une évaporation sous vide directionnelle parallèle aux flancs verticaux 4 de la cavité 7 afin de minimiser l'épaisseur de métal déposé sur ces flancs verticaux 4.

La figure 5 illustre le micromoule selon l'invention dans une étape intermédiaire obtenu en éliminant la couche conductrice 9 recouvrant les flancs verticaux 4 de la cavité 7. Cette couche conductrice 9 est éliminée de ces flancs verticaux 4 afin d'éviter l'apparition de microcavités dans le métal électroformé.

L'élimination de la couche conductrice sur les flancs verticaux 4 s'effectue par attaque chimique contrôlée. En contrôlant la durée de l'attaque, on peut contrôler l'épaisseur de métallisation qui sera enlevée. En effet, l'épaisseur de métal déposé sur les flancs verticaux 4 est plus faible que celle de l'or déposé sur les surfaces horizontales. De ce fait, la couche de métal est éliminée en premier sur ces flancs verticaux 4 tandis qu'une épaisseur d'or suffisante à la conduction électrique subsiste sur les surfaces horizontales 7a, 7b et 7c du micromoule. Le résultat illustré à la figure 5 montre que seules les surfaces horizontales 7a du fond de la cavité, 7b du premier niveau et 7c du deuxième niveau sont recouvertes par la couche conductrice 9.

La dernière étape consiste à enlever l'encre 11. En enlevant l'encre, la couche conductrice, déposée sur l'encre, est également éliminée, car elle n'a pas d'adhérence directe sur le moule en résine.

Cette étape est réalisée par une attaque chimique en utilisant un dilutif de l'encre, par exemple un solvant, tel que de l'acétone.

Il est à noter que l'étape d'attaque chimique de l'encre peut être réalisée avant l'élimination de la couche conductrice sur les flancs verticaux.

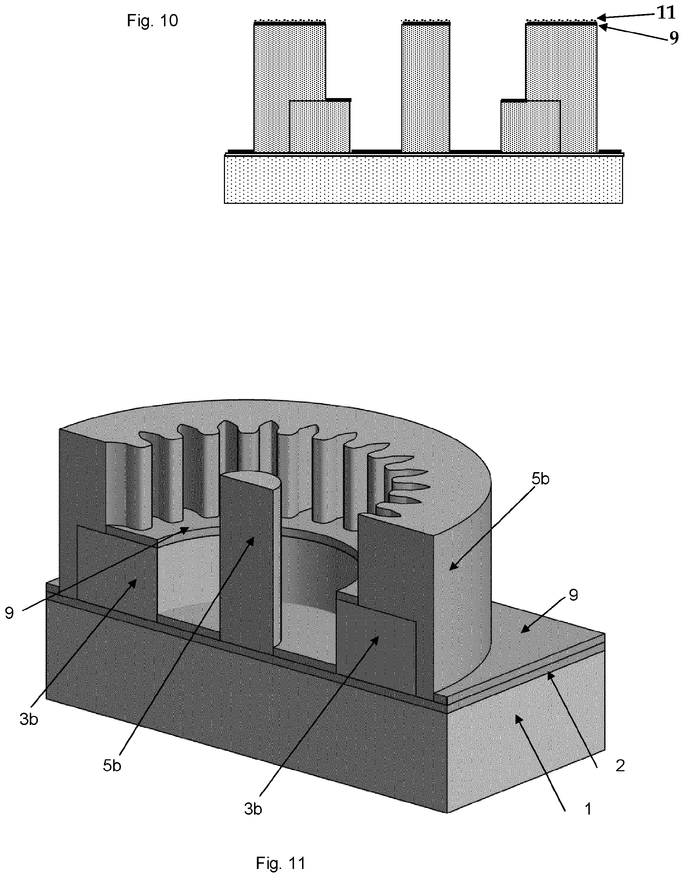

Le moule est ainsi prêt pour son utilisation et la figure 11 est un exemple d'un tel moule. La figure 11 représente une vue en perspective d'un micromoule coupé en sa moitié permettant l'électroformage d'une pièce de micromécanique, en particulier pour l'horlogerie tel que roue dentée et rehaut circulaire. Les pièces ainsi produites ont des tailles variant de 50 à 600 microns pour chacun des étages de la pièce. Un diamètre indicatif de la pièce varie entre 1 mm et 5cm, de préférence de 5mm à 20mm. La couche 5b représente le micromoule de la roue dentée avec une structure centrale qui définira un trou d'assemblage pour un axe. La couche 3b représente le micromoule du rehaut circulaire. La couche conductrice 9 est disposée sur le fond du moule, venant recouvrir la première couche conductrice 2, et sur la surface horizontale du premier niveau du moule.

Dans une autre variante, un encreur structuré peut être utilisé pour appliquer l'encre seulement sur une partie de la surface horizontale supérieure 7c. En effet, seule la partie de l'encreur en contact avec la surface horizontale va définir la surface où l'encre sera transférée.

L'encreur peut avoir une structure striée ou pointillée afin de perturber et de limiter la croissance de métal sur la face horizontale sommitale. L'encreur peut également avoir une forme en relation avec le motif sommital afin de déposer de l'encre uniquement sur le pourtour des ouvertures de la cavité 7 réalisées dans le dernier étage. L'application de l'encreur sera alors plus compliquée car il est nécessaire de l'aligner avec la cavité 7.

### B. Encrage après dépôt de la couche conductrice

En référence au moule de la figure 1, l'étape suivante est le dépôt d'une couche conductrice sur le moule. Cette couche conductrice 9, généralement constituée d'un empilement d'une couche de chrome et d'or, est déposée par une évaporation sous vide directionnelle parallèle aux flancs verticaux 4 de la cavité 7 afin de minimiser l'épaisseur de métal déposé sur ces flancs verticaux 4.

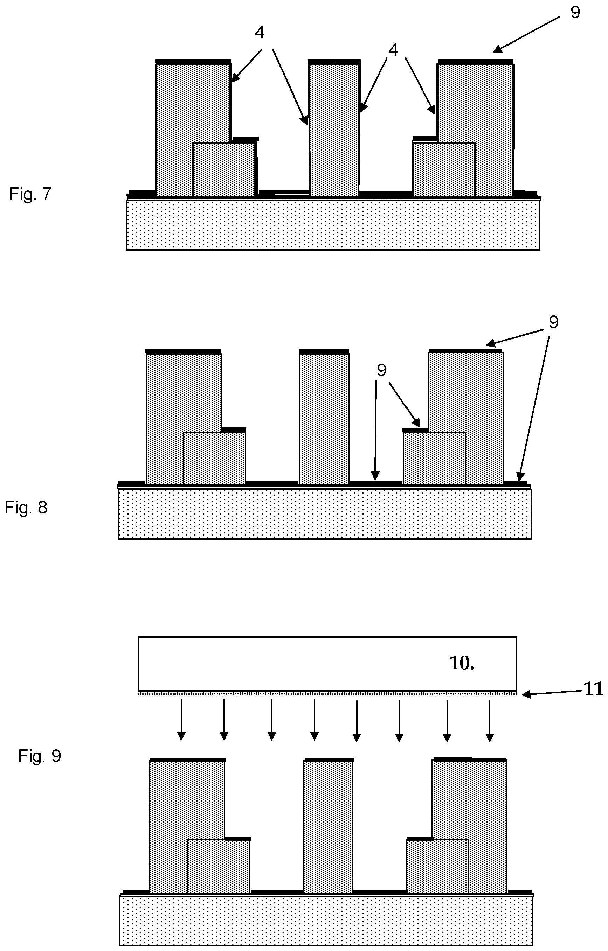

L'étape suivante est l'élimination de la couche conductrice sur les flancs verticaux 4. L'élimination de la couche conductrice sur les flancs verticaux 4 s'effectue par attaque chimique contrôlée. En contrôlant la durée de l'attaque, on peut contrôler l'épaisseur de métallisation qui sera enlevée. En effet, l'épaisseur de métal déposé sur les flancs verticaux 4 est plus faible que celle de l'or déposé sur les surfaces horizontales. De ce fait, la couche de métal est éliminée en premier sur ces flancs verticaux 4 tandis qu'une épaisseur de métal suffisante à la conduction électrique subsiste sur les surfaces horizontales du micromoule. Le résultat illustré à la figure 8 montre que seules les surfaces horizontales du fond de la cavité 7, du premier niveau et du deuxième niveau sont recouvertes par la couche conductrice 9.

La couche d'encre, telle que décrite plus haut est appliquée sur un élément de transfert ou encreur représenté sous forme d'une plaque de transfert 10. L'élément de transfert peut également être un rouleau. Lors de l'application de cette plaque de transfert 10 sur les reliefs du micromoule, cette couche 11 d'une épaisseur typique entre 1 et 20um, va être transférée sur les surfaces supérieures du moule en contact. Cette couche d'encre n'étant pas conductrice, elle va isoler la couche conductrice 9 de la partie supérieure du moule. Cette étape est illustrée à la figure 9.

Sur la figure 10, on peut voir le micromoule prêt pour l'étape d'électroformage avec sur la surface supérieure la couche conductrice 9 sur laquelle la couche d'encre 11 est disposée.

Une fois l'étape d'électroformage terminée, le moule est dissous et la couche conductrice métallique sur la surface supérieure 9 et la couche d'encre 11 sont éliminées.

Lors de la réalisation d'un micromoule les couches de photorésist sont en général aplanies par usinage avant les opérations d'irradiation de manière à obtenir une épaisseur uniforme sur toute leur surface. Ces étapes d'aplanissement de chacun des niveaux sont de préférence réalisées par un procédé connu sous le nom de « fly-cutting » utilisant un outil de coupe muni d'une extrémité coupante en métal dur, céramique, carbure métallique, nitrure métallique ou en diamant.

## Revendications

1. Méthode de fabrication de micromoules pour électroformage d'un composant micromécanique ayant au moins deux niveaux, cette méthode comprenant les étapes suivantes :
a) appliquer sur un substrat (1), illuminer et développer au moins deux couches de photorésist, soit une première couche (3) et une couche sommitale (5) pour obtenir un micromoule à au moins deux niveaux en photorésist polymérisé (3, 3b, 5 et 5b) comprenant au moins une cavité (7) comportant un fond formé par une première couche conductrice (2) recouvrant le substrat (1), des surfaces horizontales supérieures du premier niveau (7b), des surfaces horizontales supérieures de la couche sommitale (7c) et des flancs verticaux (4),
b) déposer une couche conductrice (9) sur le fond de la cavité (7a) et sur les surfaces horizontales supérieures du premier niveau (7b), le dépôt de cette couche comprenant les étapes:
i) appliquer une encre (11) sur tout ou partie des surfaces horizontales de la couche sommitale (7c) de photorésist par transfert mécanique d'un encreur (10),
ii) déposer une deuxième couche conductrice (9) sur le micromoule par une évaporation sous vide directionnelle parallèle aux flancs verticaux (4) de la cavité (7) afin de minimiser l'épaisseur de métal déposé sur ces flancs verticaux (4), l'épaisseur de métal déposée sur les flancs verticaux (4) étant plus faible que celle déposée sur les surfaces horizontales (7a, 7b et 7c),
iii) éliminer la deuxième couche conductrice (9) recouvrant les flancs verticaux (4) de la cavité (7) par attaque chimique contrôlée, ladite deuxième couche conductrice (9) recouvrant uniquement le fond de la cavité (7a) et les surfaces horizontales supérieures du premier niveau et de la couche sommitale (7b, 7c).
iv) éliminer l'encre (11) entraînant l'élimination de la couche conductrice placée sur ladite encre.

2. Méthode selon la revendication 1, **caractérisée** que ce que le moule comprend au moins trois couches de photorésist, la première couche (3), la couche sommitale (5) et au moins une couche intermédiaire, la deuxième couche conductrice (9) étant déposée sur le fond de la cavité (7a), sur les surfaces horizontales supérieures du premier niveau (7b) et les surfaces horizontales de la couche intermédiaire.

3. Méthode selon la revendication 1 ou 2, **caractérisée en ce que** les étapes iii) et iv) sont interverties.

4. Méthode selon l'une des revendications 1 à 3, **caractérisée en ce que** l'encre (11) est du type de celle utilisée en tampographie.

5. Méthode selon l'une des revendications 1 à 4, **caractérisée en ce que** l'encreur est structuré afin de définir des zones d'encrage partielles.

6. Méthode selon l'une des revendications 1 à 5, **caractérisée en ce que** l'encreur est structuré afin de permettre un encrage uniquement sur le pourtour des ouvertures de la cavité (7) réalisées dans la couche sommitale du moule.

7. Méthode selon l'une des revendications précédentes, **caractérisée en ce que** l'encreur est sous forme d'un tampon.

8. Méthode selon l'une des revendications 1 à 6, **caractérisée en ce que** l'encreur est sous forme d'un rouleau.

9. Méthode selon l'une des revendications précédentes, **caractérisée en ce que** l'encreur est à base de matière silicone.

## Patentansprüche

1. Verfahren zur Herstellung von Mikroformen für die Elektroformung eines mikromechanischen Bauteils mit mindestens zwei Ebenen, wobei das Verfahren die folgenden Schritte umfasst:
a) Aufbringen auf ein Substrat (1), Beleuchten und Entwickeln von mindestens zwei Schichten eines Photoresists, nämlich einer ersten Schicht (3) und einer obersten Schicht (5), um eine Mikroform mit mindestens zwei Ebenen aus polymerisiertem Photoresist (3, 3b, 5 und 5b) mit mindestens einem Hohlraum (7), der einen Boden aufweist, der von einer ersten leitfähigen Schicht (2), die das Substrat (1) bedeckt, oberen horizontalen Flächen der ersten Ebene (7b), oberen horizontalen Flächen der Scheitelschicht (7c) und vertikalen Flanken (4) gebildet wird,
b) Aufbringen einer leitfähigen Schicht (9) auf den Boden des Hohlraums (7a) und auf die oberen horizontalen Oberflächen der ersten Ebene (7b), wobei das Aufbringen dieser Schicht die folgenden Schritte umfasst:
i) Aufbringen einer Tinte (11) auf alle oder einen Teil der horizontalen Oberflächen der obersten Schicht (7c) des Photoresists durch mechanische Übertragung von einem Tintenmarkierer (10),
ii) Aufbringen einer zweiten leitfähigen Schicht (9) auf die Mikroform durch gerichtetes Vakuumverdampfen parallel zu den vertikalen Flanken (4) des Hohlraums (7), um die Dicke des auf diesen vertikalen Flanken (4) aufgebrachten Metalls zu minimieren, wobei die Dicke des auf den vertikalen Flanken (4) aufgebrachten Metalls geringer ist als die auf den horizontalen Oberflächen (7a, 7b und 7c) aufgebrachte Dicke,
iii) Entfernen der zweiten leitfähigen Schicht (9), die die vertikalen Flanken (4) des Hohlraums (7) bedeckt, durch kontrolliertes Ätzen, wobei die zweite leitfähige Schicht (9) nur den Boden des Hohlraums (7a) und die oberen horizontalen Oberflächen der ersten Ebene und der Gipfelschicht (7b, 7c) bedeckt,
iv) Entfernen der Tinte (11), was zur Entfernung der leitfähigen Schicht führt, die auf der Tinte angeordnet ist.

2. Verfahren nach Anspruch 1, **dadurch gekennzeichnet, dass** die Form mindestens drei Schichten des Photoresists umfasst, die erste Schicht (3), die oberste Schicht (5) und mindestens eine Zwischenschicht, wobei die zweite leitende Schicht (9) auf dem Boden des Hohlraums (7a), auf den oberen horizontalen Oberflächen der ersten Ebene (7b) und den horizontalen Oberflächen der Zwischenschicht aufgebracht wird.

3. Verfahren nach Anspruch 1 oder 2, **dadurch gekennzeichnet, dass** die Schritte iii) und iv) vertauscht werden.

4. Verfahren nach einem der Ansprüche 1 bis 3, **dadurch gekennzeichnet, dass** die Druckfarbe (11) von der Art ist, wie sie im Tampondruck verwendet wird.

5. Verfahren nach einem der Ansprüche 1 bis 4, **dadurch gekennzeichnet, dass** der Tintenmarkierer so strukturiert ist, dass er partielle Farbzonen definiert.

6. Verfahren nach einem der Ansprüche 1 bis 5, **dadurch gekennzeichnet, dass** der Tintenmarkierer so strukturiert ist, dass er nur am Umfang der Öffnungen des Hohlraums (7), die in der obersten Schicht der Form hergestellt wurden, einfärbt.

7. Verfahren nach einem der vorhergehenden Ansprüche, **dadurch gekennzeichnet, dass** der Tintenmarkierer in Form eines Stempels vorliegt.

8. Verfahren nach einem der Ansprüche 1 bis 6, **dadurch gekennzeichnet, dass** der Tintenmarkierer in Form einer Rolle vorliegt.

9. Verfahren nach einem der vorhergehenden Ansprüche, **dadurch gekennzeichnet, dass** das Farbmittel auf Silikonmaterial basiert.

## Claims

1. A method of manufacturing micromolds for electroforming a micromechanical component having at least two levels, said method comprising the following steps:
a) applying to a substrate (1), illuminating and developing at least two layers of photoresist, namely a first layer (3) and a top layer (5) to obtain a micromould with at least two levels of polymerized photoresist (3, 3b, 5 and 5b) comprising at least one cavity (7) having a bottom formed by a first conductive layer (2) covering the substrate (1), upper horizontal surfaces of the first level (7b), upper horizontal surfaces of the top layer (7c) and vertical flanks (4),
b) depositing a conductive layer (9) on the bottom of the cavity (7a) and on the upper horizontal surfaces of the first level (7b), the deposition of which comprises the steps :
i) applying an ink (11) to all or part of the horizontal surfaces of the top photoresist layer (7c) by mechanical transfer from an inker (10),
ii) depositing a second conductive layer (9) on the micromould by directional vacuum evaporation parallel to the vertical flanks (4) of the cavity (7) in order to minimize the thickness of metal deposited on these vertical flanks (4), the thickness of metal deposited on the vertical flanks (4) being smaller than that deposited on the horizontal surfaces (7a, 7b and 7c),
iii) removing the second conductive layer (9) covering the vertical sides (4) of the cavity (7) by controlled chemical etching, said second conductive layer (9) covering only the bottom of the cavity (7a) and the upper horizontal surfaces of the first level and top layer (7b, 7c).
iv) removing the ink (11), thereby removing the conductive layer on top of said ink.

2. Method according to claim 1, **characterized in that** the mold comprises at least three layers of photoresist, the first layer (3), the top layer (5) and at least one intermediate layer, the second conductive layer (9) being deposited on the bottom of the cavity (7a), on the upper horizontal surfaces of the first level (7b) and the horizontal surfaces of the intermediate layer.

3. Method according to claim 1 or 2, **characterized in that** steps iii) and iv) are reversed.

4. Method according to one of claims 1 to 3, **characterized in that** the ink (11) is of the type used in pad printing.

5. Method according to one of claims 1 to 4, **characterized in that** the inking unit is structured to define partial inking zones.

6. Method according to one of claims 1 to 5, **characterized in that** the inker is structured to allow inking only around the perimeter of the cavity openings (7) made in the top layer of the mold.

7. Method according to one of the preceding claims, **characterized in that** the inker is in the form of a pad.

8. Method according to one of claims 1 to 6, **characterized in that** the inker is in the form of a roller.

9. Method according to one of the preceding claims, **characterized in that** the inker is based on silicone material.
